# EUROPEAN PATENT APPLICATION

(11) **EP 4 386 874 A1**
(43) Date of publication of application: **19.06.2024**
(21) Application number: 22933072.5
(22) Date of filing: 28.10.2022
(51) Int. Cl.: H01L 31/18

(54) **PREPARATION METHOD AND APPLICATION OF CRYSTALLINE SILICON SOLAR CELL HAVING SHALLOW JUNCTION DIFFUSION EMITTER**

(30) Priority: 24.03.2022 CN 202210297638
(71) Applicant: Hengdian Group DMEGC Magnetics Co., Ltd., Jinhua, Zhejiang 322118 (CN)
(72) Inventor: REN, Yong, Jinhua, Zhejiang 322118 (CN); HE, Yue, Jinhua, Zhejiang 322118 (CN); REN, Hailiang, Jinhua, Zhejiang 322118 (CN); GUO, Shuai, Jinhua, Zhejiang 322118 (CN); WANG, Zaifa, Jinhua, Zhejiang 322118 (CN); LI, Zengbiao, Jinhua, Zhejiang 322118 (CN)
(74) Representative: HGF
(86) International application number: PCT/CN2022/128187
(87) International publication number: WO 2023/179021

(57) **Abstract**

The present application provides a preparation method and application of a crystalline silicon solar cell having a shallow junction diffusion emitter. The preparation method comprises a diffusion process and a chain oxidation process, the diffusion process comprises low temperature diffusion and high temperature propulsion, and the chain oxidation process comprises high-temperature chain oxidation. According to the present application, firstly, a low-doped diffusion shallow junction having a depth of 0.15 um is prepared by means of optimization of the diffusion process, and doping with a certain dose concentration is formed on the surface of a diffusion layer by using photon thermal activation radiation energy of high-temperature chain oxidation, so as to solve the mismatch problem of alloy ohmic contact subsequently formed with silver paste, and finally, the photoelectric conversion efficiency is improved to a high degree.

## Description

### TECHNICAL FIELD

The present application relates to the field of photovoltaics, to the field of crystalline silicon solar cell manufacturing, and in particular, to a preparation method for a crystalline silicon solar cell with a shallow junction diffusion emitter and use thereof.

### BACKGROUND

As the non-renewable energy sources are being exhausted and global warming is becoming serious, establishing an energy system based on renewable energy to realize green and sustainable development has become a global consensus. At present, more than 130 countries and regions around the world have successively announced their "carbon neutrality" goal, and some countries have even clarified their "carbon neutrality" responsibility through legislative ways to effectively respond to the crisis and challenges brought about by climate change. At present, the penetration rate of renewable energy around the world is still at a low level, and there is a broad space for development; for renewable energy, photovoltaic power generation has obvious economic advantages, the cost of electricity per kilowatt-hour is lower than that of coal power and will continue to decrease in the future, and the development potential should not be underestimated.

On this basis, improving the photoelectric conversion efficiency of solar cells is particularly important; the diffusion emitter junction depth of current conventional high-efficiency cells is basically around 0.2 µm - 0.3 µm, and the loss of shortwave absorption is greatly obvious; however, the attempt to use conventional diffusion process to prepare diffusion shallow junction of 0.1 µm - 0.2 µm will cause extremely high sheet resistance and low surface concentration, which will easily result in alloy ohmic contact problems in the screen process and lead to the failure of photoelectric conversion efficiency of solar cells; therefore, it is very difficult to obtain the diffusion shallow junction through the current conventional solar manufacturing process.

CN103943719A discloses a method of controlling phosphorus doping concentrations by using pre-oxidation combined with a temperature-changing diffusion method of low temperature - high temperature - low temperature; this method includes pre-oxidation and a three-step temperature-changing diffusion process which changes from a low temperature, to a high temperature, and to a low temperature; by optimizing the temperature gradient, this process can accurately control the gradient of phosphorus doping concentrations, obtain good PN junction and uniform sheet resistance, and improve the conversion efficiency of solar cells; the invention mainly describes how to control the phosphorus doping concentrations by optimization of the diffusion process, and especially, the temperature-changing diffusion process, but it only focuses on the optimization of diffusion single process, and just realizes the optimization of diffusion distribution of ECV profiles.

CN105280484A discloses a diffusion process for a high-efficiency, high-sheet resistance crystalline silicon cell slice, which mainly includes the following steps: (1) furnace loading; (2) low-temperature oxidization; (3) low-temperature vapor deposition; (4) heating impurity redistribution; (5) high-temperature vapor deposition; (6) cooling impurity redistribution; (7) low-temperature vapor deposition; (8) low-temperature impurity redistribution; and (9) furnace unloading. Similarly to CN103943719A, this patent just optimizes the diffusion process singly, and the solar photovoltaic conversion efficiency needs to be further improved.

CN204905275U discloses a device based on a chain oxidation method to enhance the anti-PID effect of solar cells, which mainly includes: an ozone generator, a compressed air delivery pipeline and a mixer; an ozone outlet of the ozone generator is connected to the mixer through an ozone delivery pipeline, compressed air is connected to the mixer through the compressed air delivery pipeline, the mixer is connected to a mixing gas outlet through a mixing gas delivery pipeline, and an outlet of the mixer is connected to a gas inlet of a flow homogenizer plate; the flow homogenizer plate is hollow, the gas inlet is arranged on one end of the flow homogenizer plate, and a plurality of gas outlets are uniformly arranged on a wall of a lower end; the homogenizer plate is arranged above a silicon wafer transfer track between an etching device and a PECVD device of a cell slice production equipment, and the gas outlets face the wafer transfer track; and the ozone generator is provided with a device controlling the amount of ozone generated. In this patent, by rapidly growing a silicon oxide film on the surface of silicon wafer before the deposition of silicon nitride film, the anti-PID effect of photovoltaic cells are improved, and the service life is extended. However, this patent focuses only on the use reliability of solar cells, and does not improve the photoelectric conversion efficiency of solar cells from the high-temperature way.

At present, the photoelectric conversion efficiency of conventional solar cells is approaching the bottleneck; how to further optimize or improve the process details is a great challenge that technical engineers struggle with, and it is important to find a new breakthrough point.

### SUMMARY

The following is a summary of the subject matter described in detail herein. This summary is not intended to limit the claim scope for which protection is sought.

An object of the present application is to provide a preparation method for a crystalline silicon solar cell with a shallow junction diffusion emitter and use thereof.

In order to achieve the object, the present application adopts the technical solutions below.

A first object of the present application is to provide a preparation method for a crystalline silicon solar cell with a shallow junction diffusion emitter, and the preparation method comprises a diffusion process and a chain oxidation process.

The diffusion process comprises low-temperature diffusion and high-temperature drive-in, and the chain oxidation process comprises high-temperature chain oxidation.

In the present application, the influence factors are analyzed through the DOE experiment of diffusion process, such as temperature, time, flow rate, and formula, and the key factors to change the ECV profiles of diffusion process are identified, such as the surface concentration, emitter junction depth, and doping diffusion curves satisfying the complementary error distribution or Gaussian distribution; secondly, based on the understanding of the mechanism of high-temperature chain oxidation, the influence factors of the surface doping are figured out by the experimental process; finally, based on the photovoltaic power generation principle of solar crystalline silicon cells, the diffusion process and the chain oxidation process are combined creatively, a diffusion emitter junction of about 0.15 µm is prepared, good ohmic alloy contacts are realized under high surface doping concentration, the absorption in shortwave spectra is improved, and the photoelectric conversion efficiency of solar cells is increased.

In the present application, firstly, the low-doping diffusion shallow junction of 0.15 µm in depth is prepared through the optimization of the diffusion process, and meanwhile, a certain dose concentration of doping is formed on the surface of diffusion layer by using the photon thermal activation radiant energy of high-temperature chain oxidation, so as to solve the subsequent mismatch problem in formation of alloy ohmic contacts with silver paste. Finally, the photoelectric conversion efficiency is greatly improved.

As a preferred technical solution of the present application, the diffusion process sequentially comprises boat loading, a first heating, a first temperature holding, vacuum stabilization, vacuum leak detection, oxidation, a first low-temperature diffusion source introduction, a second low-temperature diffusion source introduction, a second heating, a second temperature holding, high-temperature drive-in, a first cooling, complemental diffusion, purge, a PSG deposition reaction, an oxidation reaction, a second cooling, nitrogen filling, and boat unloading.

Optionally, the low-temperature diffusion comprises diffusing a constant source at a certain temperature.

Optionally, the constant source is phosphorus oxychloride.

Optionally, the low-temperature diffusion comprises the first low-temperature diffusion source introduction and the second low-temperature diffusion source introduction.

Optionally, the first low-temperature diffusion source introduction is performed at 770-790°C, wherein the temperature may be 770°C, 772°C, 774°C, 776°C, 778°C, 780°C, 782°C, 784°C, 786°C, 788°C, or 790°C, but is not limited to the listed values, and other unlisted values within the numerical range are also applicable.

Optionally, the first low-temperature diffusion source introduction is performed for 220-260 s, wherein the time may be 220 s, 225 s, 230 s, 235 s, 240 s, 245 s, 250 s, 255 s, or 260 s, but is not limited to the listed values, and other unlisted values within the numerical range are also applicable.

Optionally, the first low-temperature diffusion source introduction is performed with a low nitrogen flow rate of 1000-1100 sccm, wherein the low nitrogen flow rate may be 1000 sccm, 1020 sccm, 1040 sccm, 1060 sccm, 1080 sccm, or 1100 sccm, but is not limited to the listed values, and other unlisted values within the numerical range are also applicable.

Optionally, the first low-temperature diffusion source introduction is performed with an oxygen flow rate of 450-550 sccm, wherein the oxygen flow rate may be 450 sccm, 460 sccm, 470 sccm, 480 sccm, 490 sccm, 500 sccm, 510 sccm, 520 sccm, 530 sccm, 540 sccm, or 550 sccm, but is not limited to the listed values, and other unlisted values within the numerical range are also applicable.

Optionally, the first low-temperature diffusion source introduction is performed with a high nitrogen flow rate of 0 sccm.

Optionally, the first low-temperature diffusion source introduction is performed at a furnace tube pressure of 50-60 mbar, wherein the furnace tube pressure may be 50 mbar, 51 mbar, 52 mbar, 53 mbar, 54 mbar, 55 mbar, 56 mbar, 57 mbar, 58 mbar, 59 mbar, or 60 mbar, but is not limited to the listed values, and other unlisted values within the numerical range are also applicable.

Optionally, the second low-temperature diffusion source introduction is performed at 790-810°C, wherein the temperature may be 790°C, 792°C, 794°C, 796°C, 798°C, 800°C, 802°C, 804°C, 806°C, 808°C, or 810°C, but is not limited to the listed values, and other unlisted values within the numerical range are also applicable.

Optionally, the second low-temperature diffusion source introduction is performed for 190-230 s, wherein the time may be 190 s, 195 s, 200 s, 205 s, 210 s, 215 s, 220 s, 225 s, or 230 s, but is not limited to the listed values, and other unlisted values within the numerical range are also applicable.

Optionally, the second low-temperature diffusion source introduction is performed with a low nitrogen flow rate of 1100-1200 sccm, wherein the low nitrogen flow rate may be 1100 sccm, 1120 sccm, 1140 sccm, 1160 sccm, 1180 sccm, or 1200 sccm, but is not limited to the listed values, and other unlisted values within the numerical range are also applicable.

Optionally, the second low-temperature diffusion source introduction is performed with an oxygen flow rate of 550-650 sccm, wherein the oxygen flow rate may be 550 sccm, 560 sccm, 570 sccm, 580 sccm, 590 sccm, 600 sccm, 610 sccm, 620 sccm, 630 sccm, 640 sccm, or 650 sccm, but is not limited to the listed values, and other unlisted values within the numerical range are also applicable.

Optionally, the second low-temperature diffusion source introduction is performed with a high nitrogen flow rate of 0 sccm.

Optionally, the second low-temperature diffusion source introduction is performed at a furnace tube pressure of 50-60 mbar, wherein the furnace tube pressure may be 50 mbar, 52 mbar, 54 mbar, 56 mbar, 58 mbar, or 60 mbar, but is not limited to the listed values, and other unlisted values within the numerical range are also applicable.

In the present application, a constant source (phosphorus oxychloride) is introduced at about 800°C during the low-temperature diffusion, i.e., the diffusion is constant source diffusion, in which case the diffusion distribution curve satisfies the complementary error distribution.

As a preferred technical solution of the present application, the high-temperature drive-in comprises driving a phosphorus source on the surface of crystalline silicon into a silicon matrix at a high temperature.

Optionally, the high-temperature drive-in is performed for 350-370 s, wherein the time may be 350 s, 352 s, 354 s, 356 s, 358 s, 360 s, 362 s, 364 s, 366 s, 368 s, or 370 s, but is not limited to the listed values, and other unlisted values within the numerical range are also applicable.

Optionally, the high-temperature drive-in is performed at 800-900°C, wherein the temperature may be 800°C, 810°C, 820°C, 830°C, 840°C, 850°C, 860°C, 870°C, 880°C, 890°C, or 900°C, but is not limited to the listed values, and other unlisted values within the numerical range are also applicable.

Optionally, the high-temperature drive-in is performed with a low nitrogen flow rate of 750-850 sccm, wherein the low nitrogen flow rate may be 750 sccm, 760 sccm, 770 sccm, 780 sccm, 790 sccm, 800 sccm, 810 sccm, 820 sccm, 830 sccm, 840 sccm, or 850 sccm, but is not limited to the listed values, and other unlisted values within the numerical range are also applicable.

Optionally, the high-temperature drive-in is performed with an oxygen flow rate of 0 sccm.

Optionally, the high-temperature drive-in is performed with a high nitrogen flow rate of 950-1050 sccm, wherein the high nitrogen flow rate may be 950 sccm, 960 sccm, 970 sccm, 980 sccm, 990 sccm, 1000 sccm, 1010 sccm, 1020 sccm, 1030 sccm, 1040 sccm, or 1050 sccm, but is not limited to the listed values, and other unlisted values within the numerical range are also applicable.

Optionally, the high-temperature drive-in is performed at a furnace tube pressure of 50-60 mbar, wherein the furnace tube pressure may be 50 mbar, 51 mbar, 52 mbar, 53 mbar, 54 mbar, 55 mbar, 56 mbar, 57 mbar, 58 mbar, 59 mbar, or 60 mbar, but is not limited to the listed values, and other unlisted values within the numerical range are also applicable.

In the present application, when the introduction of source is finished and the temperature is increased to about 850°C, the high-temperature drive-in is performed with a fixed doping source under certain conditions, i.e., the constant total source diffusion is performed, in which case the diffusion distribution curve satisfies the Gaussian distribution.

As a preferred technical solution of the present application, the PSG deposition reaction is performed at 700-800°C, wherein the temperature may be 700°C, 710°C, 720°C, 730°C, 740°C, 750°C, 760°C, 770°C, 780°C, 790°C, or 800°C, but is not limited to the listed values, and other unlisted values within the numerical range are also applicable.

Optionally, the PSG deposition reaction is performed for 700-800 s, wherein the time may be 700 s, 710 s, 720 s, 730 s, 740 s, 750 s, 760 s, 770 s, 780 s, 790 s, or 800 s, but is not limited to the listed values, and other unlisted values within the numerical range are also applicable.

Optionally, the PSG deposition reaction is performed by introducing phosphorus oxychloride.

Optionally, the PSG deposition reaction is performed with a low nitrogen flow rate of 1250-1350 sccm, wherein the low nitrogen flow rate may be 1250 sccm, 1260 sccm, 1270 sccm, 1280 sccm, 1290 sccm, 1300 sccm, 1310 sccm, 1320 sccm, 1330 sccm, 1340 sccm, or 1350 sccm, but is not limited to the listed values, and other unlisted values within the numerical range are also applicable.

Optionally, the PSG deposition reaction is performed with an oxygen flow rate of 550-650 sccm, wherein the oxygen flow rate may be 550 sccm, 560 sccm, 570 sccm, 580 sccm, 590 sccm, 600 sccm, 610 sccm, 620 sccm, 630 sccm, 640 sccm, or 650 sccm, but is not limited to the listed values, and other unlisted values within the numerical range are also applicable.

Optionally, the PSG deposition reaction is performed with a high nitrogen flow rate of 0 sccm.

Optionally, the PSG deposition reaction is performed at a furnace tube pressure of 55-65 mbar, wherein the furnace tube pressure may be 55 mbar, 56 mbar, 57 mbar, 58 mbar, 59 mbar, 60 mbar, 61 mbar, 62 mbar, 63 mbar, 64 mbar, or 65 mbar, but is not limited to the listed values, and other unlisted values within the numerical range are also applicable.

As a preferred technical solution of the present application, a furnace tube is subjected to a vacuum operation in the first heating and the first temperature holding.

Optionally, a pipeline is purged by introducing a low nitrogen flow in the first temperature holding, and the purge is performed with a flow rate of 450-550 sccm, wherein the flow rate may be 450 sccm, 460 sccm, 470 sccm, 480 sccm, 490 sccm, 500 sccm, 510 sccm, 520 sccm, 530 sccm, 540 sccm, or 550 sccm, but is not limited to the listed values, and other unlisted values within the numerical range are also applicable.

Optionally, after the pressure is stabilized in the vacuum stabilization, all gas introductions are cut off and the furnace tube pressure is maintained at 50-60 mbar, wherein the pressure may be 50 mbar, 51 mbar, 52 mbar, 53 mbar, 54 mbar, 55 mbar, 56 mbar, 57 mbar, 58 mbar, 59 mbar, or 60 mbar, but is not limited to the listed values, and other unlisted values within the numerical range are also applicable.

Optionally, the oxidation comprises growing a layer of silicon oxide on the surface of a crystalline silicon wafer for protection.

As a preferred technical solution of the present application, the second heating is performed to a target temperature of 830-870°C, wherein the target temperature may be 830°C, 835°C, 840°C, 845°C, 850°C, 855°C, 860°C, 865°C, or 870°C, but is not limited to the listed values, and other unlisted values within the numerical range are also applicable.

Optionally, the second heating is performed by introducing nitrogen to remove the residual phosphorus oxychloride.

Optionally, the second heating is performed with a high nitrogen flow rate of 950-1050 sccm, wherein the high nitrogen flow rate may be 950 sccm, 960 sccm, 970 sccm, 980 sccm, 990 sccm, 1000 sccm, 1010 sccm, 1020 sccm, 1030 sccm, 1040 sccm, or 1050 sccm, but is not limited to the listed values, and other unlisted values within the numerical range are also applicable.

Optionally, the second temperature holding is performed by introducing oxygen to further react with the residual phosphorus oxychloride.

Optionally, the second temperature holding is performed with an oxygen flow rate of 550-650 sccm, wherein the oxygen flow rate may be 550 sccm, 560 sccm, 570 sccm, 580 sccm, 590 sccm, 600 sccm, 610 sccm, 620 sccm, 630 sccm, 640 sccm, or 650 sccm, but is not limited to the listed values, and other unlisted values within the numerical range are also applicable.

As a preferred technical solution of the present application, the first cooling is performed at 750-810°C, wherein the temperature may be 750°C, 760°C, 770°C, 780°C, 790°C, 800°C, or 810°C, but is not limited to the listed values, and other unlisted values within the numerical range are also applicable.

The temperature of the first cooling in the present application is used as a set temperature for complemental diffusion.

Optionally, the complemental diffusion is used to fix the localized low-doping defect of a crystalline silicon wafer caused by the high-temperature drive-in.

Optionally, the purge removes the residual phosphorus oxychloride in the furnace tube.

Optionally, the oxidation reaction removes phosphorus oxychloride introduced in the PSG deposition reaction.

Optionally, the second cooling is used to fix the lattice dislocation in a crystalline silicon wafer.

Optionally, the nitrogen filling is used to restore the atmospheric pressure in the furnace tube.

As a preferred technical solution of the present application, the chain oxidation process comprises high-temperature chain oxidation.

Optionally, the high-temperature chain oxidation is performed at 660-670°C, wherein the temperature may be 660°C, 662°C, 664°C, 666°C, 668°C, or 670°C, but is not limited to the listed values, and other unlisted values within the numerical range are also applicable.

Optionally, the high-temperature chain oxidation is performed for 1-5 min, wherein the time may be 1 min, 2 min, 3 min, 4 min, or 5 min, but is not limited to the listed values, and other unlisted values within the numerical range are also applicable.

Optionally, the high-temperature chain oxidation is performed with an oxygen flow rate of 95-105 slm, wherein the oxygen flow rate may be 95 slm, 96 slm, 97 slm, 98 slm, 99 slm, 100 slm, 101 slm, 102 slm, 103 slm, 104 slm, or 105 slm, but is not limited to the listed values, and other unlisted values within the numerical range are also applicable.

Optionally, the high-temperature chain oxidation is performed with a nitrogen flow rate of 5-15 slm, wherein the nitrogen flow rate may be 5 slm, 6 slm, 7 slm, 8 slm, 9 slm, 10 slm, 11 slm, 12 slm, 13 slm, 14 slm, or 15 slm, but is not limited to the listed values, and other unlisted values within the numerical range are also applicable.

In the present application, the doping distribution of the diffusion curve of the present application is established by controlling the amount of low-temperature diffusion source and the time of high-temperature drive-in. However, a low surface doping concentration of the diffusion curve will lead to the failure of the subsequent alloy ohmic contacts, and therefore, it is necessary to introduce the high-temperature chain oxidation to activate the surface doping.

A high-temperature chain oxidation furnace is a heat treatment method with a very high heating rate and a very short temperature-holding period. The heating rate can reach 10-100 °C/s. Generally, infrared halogen lamps are employed for heating, and during the heating, the current and power are high. Tungsten halogen lamps emit a large number of high-energy electrons during the heating process, the high-energy electrons bombard silicon wafers, and the radiant electrons act on the lattice and destroy the position of the atoms in the lattice, causing atom displacement effects, and at the same time, vacancy-interstitial atom pairs are also formed; meanwhile, phosphorus diffusion occurs, and there are two ways of phosphorus diffusion: interstitial diffusion and substitutional diffusion, and the bombardment of high-energy electrons reduces the difficulty of phosphorus diffusion. The chain oxidation equipment uses tungsten halogen infrared lamps to perform heating, with the presence of a constant source on the silicon wafer surface, triggers the diffusion enhancement mechanism, resulting in phosphorus source redistribution.

Based on the principle described above, the high-temperature chain oxidation is performed under different temperature conditions; it is found that when the temperature is higher, the ability of photon thermal excitation radiation will be stronger, the doping-activation ability of effective diffusion will be stronger, and the change of film sheet resistance will be larger; the different chain oxidation temperatures have their respective sheet resistance variation differences; the larger difference means that the doping-activation ability is stronger. Therefore, the present application employs high-temperature photon thermal excitation radiation to activate phosphorus doping.

As a preferred technical solution of the present application, the preparation method sequentially comprises the following processes:
a texturing process, the diffusion process, a laser doping process, the chain oxidation process, a PSG removal process, a rear-side alkali polishing process, an annealing process, an ALD passivation process, a PECVD process for the front side, a PECVD process for the rear side, a laser grooving process, a screen-printing process, and a current injection process.

In the present application, except the diffusion process and the chain oxidation process, the others all adopt the conventional processes which will not be needlessly described herein.

A second object of the present application is to provide use of the preparation method for a crystalline silicon solar cell with a shallow junction diffusion emitter as described in the first object, and the preparation method is applied in the field of photovoltaics.

Compared with the prior art, the present application has the following beneficial effects:
the conversion efficiency of the solar cell prepared in the present application is improved by 0.1% relative to the conventional solar cells.

### BRIEF DESCRIPTION OF DRAWINGS

FIG. 1 is an ECV profile showing impurity distribution for phosphorus diffusion in an embodiment of the present application.
FIG. 2 is ECV profiles showing impurity distribution for diffusion under two conditions in an embodiment of the present application.
FIG. 3 is a structural diagram of a chain oxidation furnace in an embodiment of the present application.
FIG. 4 is high-temperature chain oxidation doping profiles (with/without a PSG layer) in an embodiment of the present application.
FIG. 5 is a process flow chart for a solar cell in an embodiment of the present application.
FIG. 6 is doping distribution profiles in an embodiment of the present application.
FIG. 7 is QE quantum efficiency spectra in Example 1 and Comparative Example 1 of the present application.
FIG. 8 is ECV doping concentration distribution profiles in Example 1 and Comparative Example 1 of the present application.

### DETAILED DESCRIPTION

The technical solutions of the present application are further elaborated below in terms of embodiments. It should be clear to those skilled in the art that the examples are merely used for a better understanding of the present application and should not be regarded as a specific limitation to the present application.

The present application provides a preparation method for a crystalline silicon solar cell with a shallow junction diffusion emitter, and the preparation method comprises a diffusion process and a chain oxidation process.

The diffusion process comprises low-temperature diffusion and high-temperature drive-in, and the chain oxidation process comprises high-temperature chain oxidation.

In the present application, the influence factors are analyzed through the DOE experiment of diffusion process, such as the temperature, time, flow rate, and formula, and the key factors to change the ECV profiles of diffusion process are identified, such as the surface concentration, emitter junction depth, and doping diffusion curves satisfying the complementary error distribution or Gaussian distribution; secondly, based on the understanding of the mechanism of high-temperature chain oxidation, the influence factors of the surface doping are figured out by the experimental process; finally, based on the photovoltaic power generation principle of solar crystalline silicon cells, the diffusion process and the chain oxidation process are combined creatively, a diffusion emitter junction of about 0.15 µm is prepared, good ohmic alloy contacts are realized under high surface doping concentration, the absorption in shortwave spectra is improved, and the photoelectric conversion efficiency of solar cells is increased.

In the present application, firstly, the low-doping diffusion shallow junction of 0.15 µm in depth is prepared through the optimization of the diffusion process, and meanwhile, a certain dose concentration of doping is formed on the surface of diffusion layer by using the photon thermal activation radiant energy of high-temperature chain oxidation, so as to solve the subsequent mismatch problem in formation of alloy ohmic contacts with silver paste. Finally, the photoelectric conversion efficiency is greatly improved.

Furthermore, the diffusion process sequentially comprises boat loading, a first heating, a first temperature holding, vacuum stabilization, vacuum leak detection, oxidation, a first low-temperature diffusion source introduction, a second low-temperature diffusion source introduction, a second heating, a second temperature holding, high-temperature drive-in, a first cooling, complemental diffusion, purge, a PSG deposition reaction, an oxidation reaction, a second cooling, nitrogen filling, and boat unloading.

Furthermore, the low-temperature diffusion comprises diffusing a constant source at a certain temperature.

Furthermore, the constant source is phosphorus oxychloride.

Furthermore, the low-temperature diffusion comprises the first low-temperature diffusion source introduction and the second low-temperature diffusion source introduction.

Furthermore, the first low-temperature diffusion source introduction is performed at 770-790°C.

Furthermore, the first low-temperature diffusion source introduction is performed for 220-260 s.

Furthermore, the first low-temperature diffusion source introduction is performed with a low nitrogen flow rate of 1000-1100 sccm.

Furthermore, the first low-temperature diffusion source introduction is performed with an oxygen flow rate of 450-550 sccm.

Furthermore, the first low-temperature diffusion source introduction is performed with a high nitrogen flow rate of 0 sccm.

Furthermore, the first low-temperature diffusion source introduction is performed at a furnace tube pressure of 50-60 mbar.

Furthermore, the second low-temperature diffusion source introduction is performed at 790-810°C.

Furthermore, the second low-temperature diffusion source introduction is performed for 190-230 s.

Furthermore, the second low-temperature diffusion source introduction is performed with a low nitrogen flow rate of 1100-1200 sccm.

Furthermore, the second low-temperature diffusion source introduction is performed with an oxygen flow rate of 550-650 sccm.

Furthermore, the second low-temperature diffusion source introduction is performed with a high nitrogen flow rate of 0 sccm.

Furthermore, the second low-temperature diffusion source introduction is performed at a furnace tube pressure of 50-60 mbar.

In the present application, a constant source (phosphorus oxychloride) is introduced at a limited temperature of the present application during the low-temperature diffusion, i.e., the diffusion is constant source diffusion, in which case the diffusion distribution curve satisfies the complementary error distribution. The low-temperature diffusion (complementary error distribution) and high-temperature drive-in (Gaussian distribution) compose the impurity distribution curve of phosphorus diffusion doping.

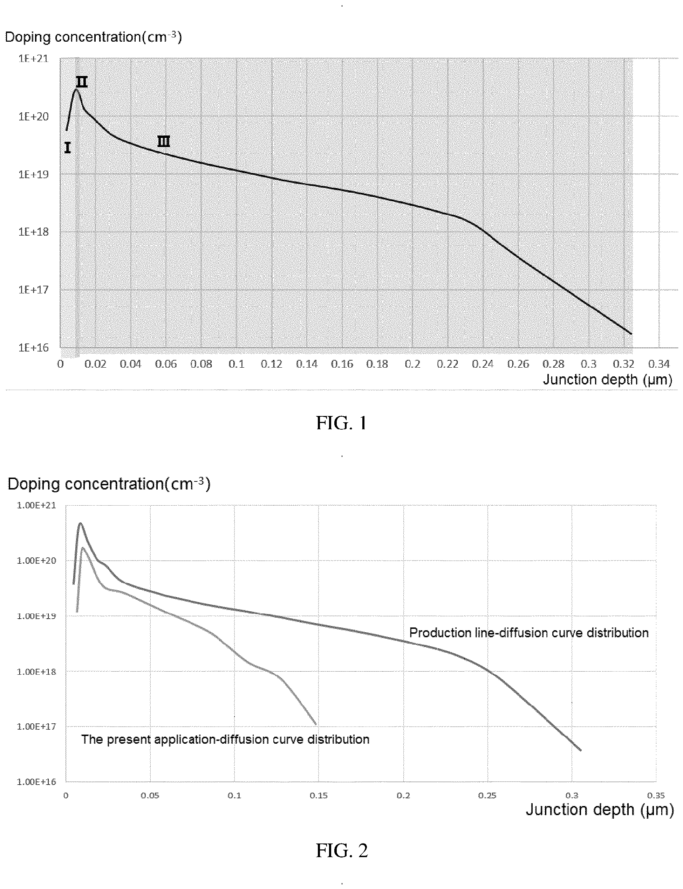

The impurity distribution curve of phosphorus diffusion doping is shown in FIG. 1, where I is associated with PSG layer doping; on one hand, SE laser doping is promoted, and on the other hand, thermal photon radiation can activate doping by the high-temperature chain thermal oxidation; II is associated with surface layer doping; on one hand, a high concentration of doping will bring about dead layers caused by the lattice mismatch and reduce the shortwave response, and on the other hand, a low concentration of doping will affect the subsequent screen in ohmic contacts; III is a junction depth curve, which on one hand affects the ohmic contacts of the paste, and on the other hand, associated with photo-induced absorption.

Furthermore, the high-temperature drive-in comprises driving a phosphorus source on the surface of crystalline silicon into a silicon matrix at a high temperature.

Furthermore, the high-temperature drive-in is performed for 350-370 s.

Furthermore, the high-temperature drive-in is performed at 800-900°C.

Furthermore, the high-temperature drive-in is performed with a low nitrogen flow rate of 750-850 sccm.

Furthermore, the high-temperature drive-in is performed with an oxygen flow rate of 0 sccm.

Furthermore, the high-temperature drive-in is performed with a high nitrogen flow rate of 950-1050 sccm.

Furthermore, the high-temperature drive-in is performed at a furnace tube pressure of 50-60 mbar.

Furthermore, the PSG deposition reaction is performed at 700-800°C.

Furthermore, the PSG deposition reaction is performed for 700-800 s.

Furthermore, the PSG deposition reaction is performed by introducing phosphorus oxychloride.

Furthermore, the PSG deposition reaction is performed with a low nitrogen flow rate of 1250-1350 sccm.

Furthermore, the PSG deposition reaction is performed with an oxygen flow rate of 550-650 sccm.

Furthermore, the PSG deposition reaction is performed with a high nitrogen flow rate of 0 sccm.

Furthermore, the PSG deposition reaction is performed at a furnace tube pressure of 55-65 mbar.

In the present application, the doping distribution of the diffusion curve of the present application is established by controlling the amount of low-temperature diffusion source and the time of high-temperature drive-in. As shown in FIG. 2, it can be seen that the shallow emitter of about 0.15 µm is prepared in the present application, but at the same time, the surface doping concentration shown by the diffusion curve is relatively low, which will lead to the failure of the subsequent alloy ohmic contacts, and therefore, it is necessary to introduce the high-temperature chain oxidation to activate the surface doping.

Furthermore, the chain oxidation process comprises: oxidation chamber loading, high-temperature chain oxidation, and oxidation chamber unloading.

Furthermore, the high-temperature chain oxidation is performed at 660-670°C.

Furthermore, the high-temperature chain oxidation is performed for 1-5 min.

Furthermore, the high-temperature chain oxidation is performed with an oxygen flow rate of 95-105 slm.

Furthermore, the high-temperature chain oxidation is performed with a nitrogen flow rate of 5-15 slm.

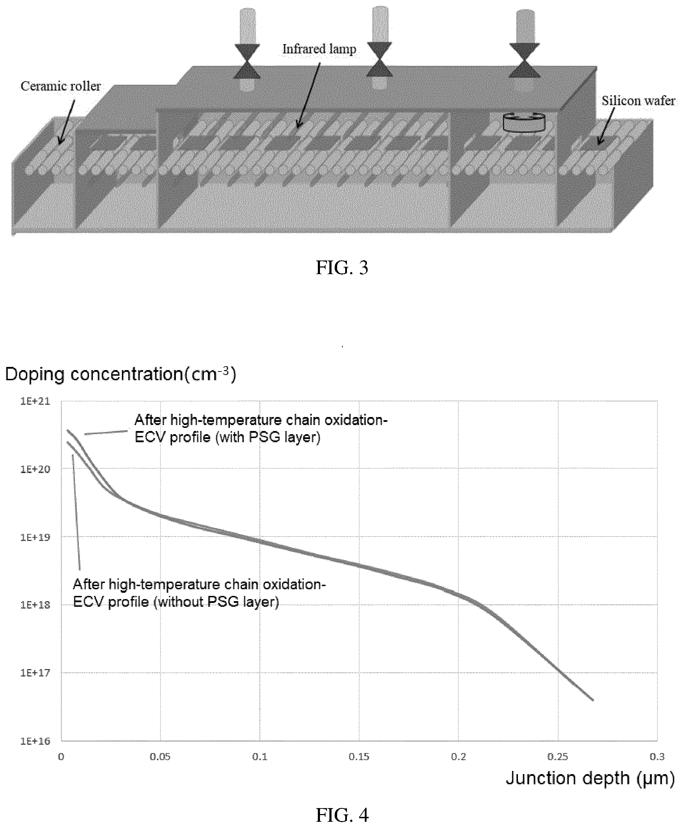

In the present application, the chain oxidation furnace shown in FIG. 3 is used for heating, and the current and power are high during the heating. Tungsten halogen lamps emit a large number of high-energy electrons during the heating process, the high-energy electrons bombard silicon wafers, and the radiant electrons act on the lattice and destroy the position of the atoms in the lattice, causing atom displacement effects, and at the same time, vacancy-interstitial atom pairs are also formed; meanwhile, phosphorus diffusion occurs, and there are two ways of phosphorus diffusion: interstitial diffusion and substitutional diffusion, and the bombardment of high-energy electrons reduces the difficulty of phosphorus diffusion. The chain oxidation equipment uses tungsten halogen infrared lamps to perform heating, and with the presence of a constant source on the silicon wafer surface, triggers the diffusion enhancement mechanism, resulting in phosphorus source redistribution.

In the present application, it is found through experiments that the PSG doping layer (FIG. 1-I) is the source for surface phosphorus activation doping under chain oxidation conditions, and the surface concentration shows different changes after chain oxidation with or without the PSG layer; as shown in FIG. 4, the wafer with PSG layer retained and wafer with PSG layer removed have different surface doping concentrations shown by the ECV test profiles after the high-temperature chain oxidation, and the doping curve obtained from high-temperature chain oxidation with the PSG layer retained is a key solution to handle the surface doping influence on alloy ohmic contacts.

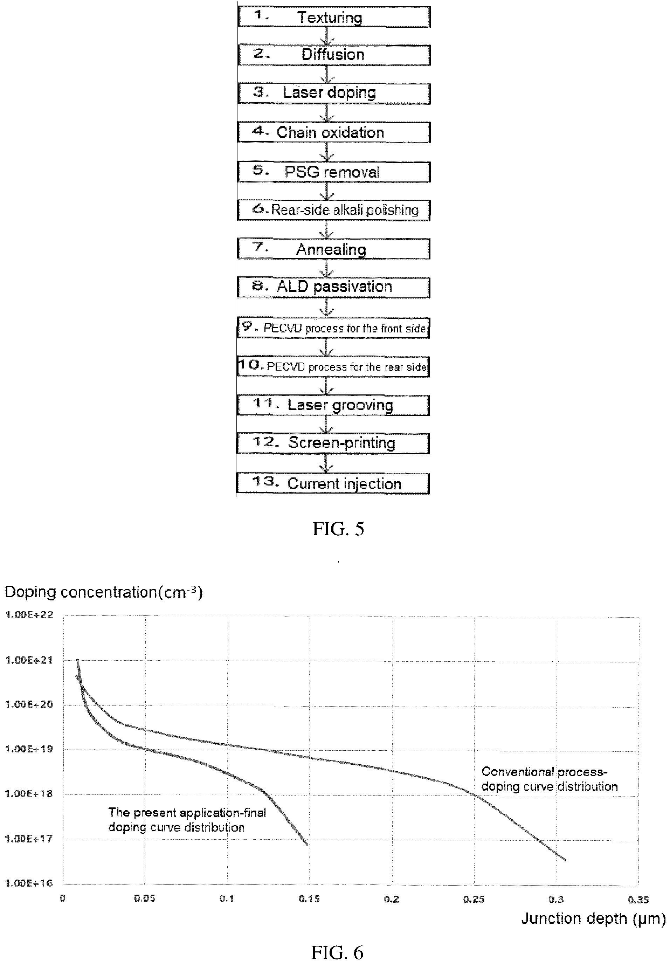

Furthermore, as shown in FIG. 5, the preparation method sequentially comprises the following processes:
a texturing process, the diffusion process, a laser doping process, the chain oxidation process, a PSG removal process, a rear-side alkali polishing process, an annealing process, an ALD passivation process, a PECVD process for the front side, a PECVD process for the rear side, a laser grooving process, a screen-printing process, and a current injection process.

In order to better understand the preparation method for a crystalline silicon solar cell with a shallow junction diffusion emitter in the present application, the examples and comparative examples below are used for illustration.

### Example 1

This example provides a preparation method for a crystalline silicon solar cell with a shallow junction diffusion emitter.

The preparation method sequentially comprises the following processes, as shown in FIG. 5:
a texturing process, a diffusion process, a laser doping process, a chain oxidation process, a PSG removal process, a rear-side alkali polishing process, an annealing process, an ALD passivation process, a PECVD process for the front side, a PECVD process for the rear side, a laser grooving process, a screen-printing process, and a current injection process.

Among the processes, the diffusion process comprises the following steps:
(1) crystalline silicon wafers for the diffusion were neatly inserted onto a quartz boat waiting to be conveyed into a furnace tube;
(2) boat loading: the crystalline silicon wafers were sent into a high-temperature quartz furnace tube, for which a time parameter was set at 630 s, a temperature parameter was set at 770°C, a nitrogen-introducing flow rate was set at 2000 sccm, and a pressure parameter was set at 1000 mbar, close to the atmospheric pressure;
(3) first heating: when the furnace tube was heated to the set temperature, a time parameter was set at 60 s, a temperature parameter was set at 770°C, a nitrogen flow rate was set at 2000 sccm, and a vacuum pressure parameter of the furnace tube was set at 700 mbar, and the furnace tube was subjected to a pre-vacuum operation;
(4) first temperature holding: when the furnace tube remained stable within the range of the set temperature ± 5°C, and the furnace tube was subjected to a vacuum operation, a time parameter was set at 180 s, a temperature parameter was set at 770°C, a nitrogen flow rate was set at 2000 sccm, and a pressure parameter of the furnace tube was set at 55 mbar, and additionally, a low nitrogen flow (phosphorus oxychloride was cut off) was introduced in advance to purge a pipeline with a flow rate set at 500 sccm;
(5) vacuum stabilization: when the furnace tube was vacuumized to the set vacuum pressure, a time parameter was set at 60 s, a temperature parameter was set at 770°C, all the gas introductions were cut off, and a pressure parameter of the furnace tube was set at 55 mbar;
(6) vacuum leak detection: the furnace tube was checked for cracks and untight seal in case that the vacuum pressure rose or fluctuated; a time parameter was set at 60 s, a temperature parameter was set at 770°C, all the gas introductions were cut off, and a pressure parameter of the furnace tube was set at 55 mbar;
(7) oxidation: the crystalline silicon wafers needed to grow a layer of silicon oxide on the surface before doping diffusion to protect the surface of crystalline silicon wafers from corrosion by phosphorus oxychloride in the subsequent reaction process; a time parameter was set at 300 s, a temperature parameter was set at 775°C, a flow rate of the low nitrogen flow (phosphorus oxychloride was cut off) was set at 500 sccm, a flow rate of oxygen was set at 900 sccm, a flow rate of a high nitrogen flow was 0, and a pressure parameter of the furnace tube was set at 55 mbar;
(8) first low-temperature diffusion source introduction: a first phosphorus oxychloride diffusion doping reaction was performed at 775°C, wherein a time parameter was set at 240 s, a temperature parameter was set at 775°C, a flow rate of the low nitrogen flow (phosphorus oxychloride was introduced) was set at 1050 sccm, a flow rate of oxygen was set at 500 sccm, a flow rate of the high nitrogen flow was 0, and a pressure parameter of the furnace tube was set at 55 mbar;
(9) second low-temperature diffusion source introduction: the temperature parameter was adjusted to 795°C and then a second phosphorus oxychloride diffusion doping reaction was performed; the purpose is to activate the doping phosphorus source in the oxidation layer by the temperature-changing diffusion, so that the diffusion reaction is more uniform; a time parameter was set at 210 s, a temperature parameter was set at 795°C, a flow rate of the low nitrogen flow (phosphorus oxychloride was introduced) was set at 1150 sccm, a flow rate of oxygen was set at 600 sccm, a flow rate of the high nitrogen flow was 0, and a pressure parameter of the furnace tube was set at 55 mbar;
(10) second heating: the second heating was a process of increasing the temperature from 795°C to 850°C to realize the subsequent high-temperature doping drive-in reaction; meanwhile, a large amount of nitrogen was introduced to carry away part of the residual phosphorus oxychloride to avoid safety risks; a time parameter was set at 300 s, a temperature parameter was set at 850°C, a flow rate of the low nitrogen flow (phosphorus oxychloride was cut off) was set at 800 sccm, a flow rate of oxygen was set at 0 sccm, a flow rate of the high nitrogen flow was 1000 sccm, and a pressure parameter of the furnace tube was set at 55 mbar;
(11) second temperature holding: the temperature needed to be held stably for a period after rising up to the set temperature; meanwhile, a certain amount of oxygen was introduced to remove the residual phosphorus oxychloride by reacting to avoid safety risks; a time parameter was set at 240 s, a temperature parameter was set at 850°C, a flow rate of the low nitrogen flow (phosphorus oxychloride was cut off) was set at 500 sccm, a flow rate of oxygen was set at 600 sccm, a flow rate of the high nitrogen flow was 500 sccm, and a pressure parameter of the furnace tube was set at 55 mbar;
(12) high-temperature drive-in: when the temperature reached the set high temperature and assuredly no reaction gas remained in the furnace tube, the high-temperature doping drive-in operation was performed to drive the phosphorus source of the crystalline silicon surface to the silicon matrix; the time and temperature are very critical to this step and will directly affect the junction depth of the diffusion emitter; a time parameter was set at 360 s, a temperature parameter was set at 850°C, a flow rate of the low nitrogen flow (phosphorus oxychloride was cut off) was set at 800 sccm, a flow rate of oxygen was set at 0 sccm, a flow rate of the high nitrogen flow was 1000 sccm, and a pressure parameter of the furnace tube was set at 55 mbar;
(13) first cooling: the temperature was reduced to about 800°C as a set temperature for complemental diffusion, wherein a time parameter was set at 1380 s, a temperature parameter was set at 790°C, a flow rate of the low nitrogen flow (phosphorus oxychloride was cut off) was set at 800 sccm, a flow rate of oxygen was set at 0 sccm, a flow rate of the high nitrogen flow was 1000 sccm, and a pressure parameter of the furnace tube was set at 55 mbar;
(14) complemental diffusion: the complemental diffusion can fix the localized low-doping problem of crystalline silicon wafers brought by high-temperature drive-in; a time parameter was set at 90 s, a temperature parameter was set at 790°C, a flow rate of the low nitrogen flow (phosphorus oxychloride was introduced) was set at 1300 sccm, a flow rate of oxygen was set at 600 sccm, a flow rate of the high nitrogen flow was 0, and a pressure parameter of the furnace tube was set at 60 mbar;
(15) purge: after the diffusion was completed, the residual phosphorus oxychloride in the furnace tube was removed thoroughly by nitrogen and vacuuming, wherein a time parameter was set at 120 s, a temperature parameter was set at 780°C, a flow rate of the low nitrogen flow (phosphorus oxychloride was cut off) was set at 800 sccm, a flow rate of oxygen was set at 0 sccm, a flow rate of the high nitrogen flow was 1000 sccm, and a pressure parameter of the furnace tube was set at 60 mbar;
(16) PSG deposition reaction: this step can, on one hand, provide sufficient phosphorus source for the subsequent laser localized doping, and on the other hand, match with the subsequent high-temperature chain oxidation for phosphorus source activation and high surface doping which is a significant finding from the present application; a time parameter was set at 760 s, a temperature parameter was set at 750°C, a flow rate of the low nitrogen flow (phosphorus oxychloride was introduced) was set at 1300 sccm, a flow rate of oxygen was set at 600 sccm, a flow rate of the high nitrogen flow was 0 sccm, and a pressure parameter of the furnace tube was set at 60 mbar;
(17) oxidation reaction: a large amount of oxygen was introduced to thoroughly remove the residual phosphorus oxychloride in the furnace tube by reacting to avoid leakage risks caused by the subsequent furnace door opening; a time parameter was set at 180 s, a temperature parameter was set at 700°C, a flow rate of the low nitrogen flow (phosphorus oxychloride was cut off) was set at 500 sccm, a flow rate of oxygen was set at 1500 sccm, a flow rate of the high nitrogen flow was 0, and a pressure parameter of the furnace tube was set at 60 mbar;
(18) second cooling: the temperature was set at a very low value in this step of cooling, the purpose is to subject the crystalline silicon wafers after undergoing diffusion to a temperature-changing process, and such process will promote the displacement of the lattice, partially fix the lattice dislocation caused by high-temperature diffusion, and further improve the quality of the diffusion emitter; a time parameter was set at 360 s, a temperature parameter was set at 700°C, a flow rate of the low nitrogen flow (phosphorus oxychloride was cut off) was set at 1000 sccm, a flow rate of oxygen was set at 0 sccm, a flow rate of the high nitrogen flow was 0 sccm, and a pressure parameter of the furnace tube was set at 60 mbar;
(19) nitrogen filling: the furnace tube was filled with a large amount of nitrogen to restore the atmospheric pressure, so as to prepare for the subsequent furnace door opening and crystalline silicon wafer taking, wherein a time parameter was set at 240 s, a temperature parameter was set at 700°C, a flow rate of the low nitrogen flow (phosphorus oxychloride was cut off) was set at 1000 sccm, a flow rate of oxygen was set at 0 sccm, a flow rate of the high nitrogen flow was 3000 sccm, and a pressure parameter of the furnace tube was set at 1000 mbar; and
(20) boat unloading the furnace door was opened, the quartz boat was taken out, and the entire diffusion process was completed; a time parameter was set at 630 s, a temperature parameter was set at 750°C, a flow rate of the low nitrogen flow was set at 0 sccm, a flow rate of oxygen was set at 0 sccm, a flow rate of the high nitrogen flow was 2000 sccm, and a pressure parameter of the furnace tube was set at 1000 mbar;
wherein the chain oxidation process comprises the following steps:
(1) carrier box loading: a carrier box containing crystalline silicon wafers was put on an automated loading machine;
(2) preparation for being conveyed into an oxidation chamber: the crystalline silicon wafers were pushed out of the carrier box and neatly arranged on a conveyor belt in front of the chain oxidation furnace chamber;
(3) the crystalline silicon wafers were conveyed into the high-temperature oxidation furnace chamber, wherein a speed of the conveyor belt was set at 3.8 m/min, a temperature parameter of an infrared halogen lamp was set at 665°C, a flow rate of oxygen was 100 slm, a flow rate of nitrogen was 10 slm;
(4) the crystalline silicon wafers were conveyed out of the oxidation chamber; the silicon wafers after undergoing high-temperature chain oxidation activation were arranged integrally on an unloading end via the conveyor belt, waiting to be sent into the carrier box; and
(5) the crystalline silicon wafers were put into the carrier box; the crystalline silicon wafers after undergoing oxidation activation were sequentially pushed into the carrier box from the conveyor belt, and, after wafer loading, sent to the subsequent PSG removal process.

### Example 2

In this example, step (8) of the diffusion process is replaced with the following operations: first low-temperature diffusion source introduction: a first phosphorus oxychloride diffusion doping reaction was performed at 770°C, wherein a time parameter was set at 260 s, a temperature parameter was set at 770°C, a flow rate of the low nitrogen flow (phosphorus oxychloride was introduced) was set at 1000 sccm, a flow rate of oxygen was set at 450 sccm, a flow rate of the high nitrogen flow was 0, and a pressure parameter of the furnace tube was set at 50 mbar;
step (9) of the diffusion process is replaced with the following operations: second low-temperature diffusion source introduction: the temperature parameter was adjusted to 790°C and then a second phosphorus oxychloride diffusion doping reaction was performed; the purpose is to activate the doping phosphorus source in the oxidation layer by the temperature-changing diffusion, so that the diffusion reaction is more uniform; a time parameter was set at 230 s, a temperature parameter was set at 790°C, a flow rate of the low nitrogen flow (phosphorus oxychloride was introduced) was set at 1100 sccm, a flow rate of oxygen was set at 550 sccm, a flow rate of the high nitrogen flow was 0, and a pressure parameter of the furnace tube was set at 50 mbar;
step (12) of the diffusion process is replaced with the following operations: high-temperature drive-in: when the temperature reached the set high temperature and assuredly no reaction gas remained in the furnace tube, the high-temperature doping drive-in operation was performed to drive the phosphorus source of the crystalline silicon surface to the silicon matrix; the time and temperature are very critical to this step and will directly affect the junction depth of the diffusion emitter; a time parameter was set at 370 s, a temperature parameter was set at 800°C, a flow rate of the low nitrogen flow (phosphorus oxychloride was cut off) was set at 750 sccm, a flow rate of oxygen was set at 0 sccm, a flow rate of the high nitrogen flow was 950 sccm, and a pressure parameter of the furnace tube was set at 50 mbar;
step (16) of the diffusion process is replaced with the following operations: PSG deposition reaction: this step can, on one hand, provide sufficient phosphorus source for the subsequent laser localized doping, and on the other hand, match with the subsequent high-temperature chain oxidation for phosphorus source activation and high surface doping which is a significant finding from the present application; a time parameter was set at 800 s, a temperature parameter was set at 700°C, a flow rate of the low nitrogen flow (phosphorus oxychloride was introduced) was set at 1250 sccm, a flow rate of oxygen was set at 550 sccm, a flow rate of the high nitrogen flow was 0 sccm, and a pressure parameter of the furnace tube was set at 55 mbar;
step (3) of the chain oxidation process is replaced with the following operations: the crystalline silicon wafers were conveyed into the high-temperature oxidation furnace chamber, wherein a speed of the conveyor belt was set at 3.8 m/min, a temperature parameter of an infrared halogen lamp was set at 660°C, a flow rate of oxygen was 95 slm, a flow rate of nitrogen was 5 slm.

All other conditions are the same as in Example 1.

### Example 3

In this example, step (8) of the diffusion process is replaced with the following operations: first low-temperature diffusion source introduction: a first phosphorus oxychloride diffusion doping reaction was performed at 790°C, wherein a time parameter was set at 220 s, a temperature parameter was set at 790°C, a flow rate of the low nitrogen flow (phosphorus oxychloride was introduced) was set at 1100 sccm, a flow rate of oxygen was set at 550 sccm, a flow rate of the high nitrogen flow was 0, and a pressure parameter of the furnace tube was set at 60 mbar;
step (9) of the diffusion process is replaced with the following operations: second low-temperature diffusion source introduction: the temperature parameter was adjusted to 810°C and then a second phosphorus oxychloride diffusion doping reaction was performed; the purpose is to activate the doping phosphorus source in the oxidation layer by the temperature-changing diffusion, so that the diffusion reaction is more uniform; a time parameter was set at 190 s, a temperature parameter was set at 1200°C, a flow rate of the low nitrogen flow (phosphorus oxychloride was introduced) was set at 650 sccm, a flow rate of oxygen was set at 650 sccm, a flow rate of the high nitrogen flow was 0, and a pressure parameter of the furnace tube was set at 60 mbar;
step (12) of the diffusion process is replaced with the following operations: high-temperature drive-in: when the temperature reached the set high temperature and assuredly no reaction gas remained in the furnace tube, the high-temperature doping drive-in operation was performed to drive the phosphorus source of the crystalline silicon surface to the silicon matrix; the time and temperature are very critical to this step and will directly affect the junction depth of the diffusion emitter; a time parameter was set at 350 s, a temperature parameter was set at 900°C, a flow rate of the low nitrogen flow (phosphorus oxychloride was cut off) was set at 850 sccm, a flow rate of oxygen was set at 0 sccm, a flow rate of the high nitrogen flow was 1050 sccm, and a pressure parameter of the furnace tube was set at 60 mbar;
step (16) of the diffusion process is replaced with the following operations: PSG deposition reaction: this step can, on one hand, provide sufficient phosphorus source for the subsequent laser localized doping, and on the other hand, match with the subsequent high-temperature chain oxidation for phosphorus source activation and high surface doping which is a significant finding from the present application; a time parameter was set at 700 s, a temperature parameter was set at 800°C, a flow rate of the low nitrogen flow (phosphorus oxychloride was introduced) was set at 1350 sccm, a flow rate of oxygen was set at 650 sccm, a flow rate of the high nitrogen flow was 0 sccm, and a pressure parameter of the furnace tube was set at 65 mbar;
step (3) of the chain oxidation process is replaced with the following operations: the crystalline silicon wafers were conveyed into the high-temperature oxidation furnace chamber, wherein a speed of the conveyor belt was set at 3.8 m/min, a temperature parameter of an infrared halogen lamp was set at 670°C, a flow rate of oxygen was 105 slm, a flow rate of nitrogen was 15 slm.

All other conditions are the same as in Example 1.

### Example 4

In this example, the temperature parameter of the first low-temperature diffusion source introduction is replaced with 700°C in step (8) of the diffusion process, and all other conditions are the same as in Example 1.

### Example 5

In this example, the temperature parameter of the high-temperature drive-in is set at 950°C in step (12) of the diffusion process, and all other conditions are the same as in Example 1.

### Example 6

In this example, the temperature parameter of the infrared halogen lamp is set at 700°C instead of 665°C in the high-temperature chain oxidation process, and all other conditions are the same as in Example 1.

### Example 7

In this example, the second low-temperature diffusion source introduction of step (9) of the diffusion process is omitted, and all other conditions are the same as in Example 1.

### Example 8

In this example, the PSG deposition reaction of step (16) of the diffusion process is omitted, and all other conditions are the same as in Example 1.

### Comparative Example 1

In this comparative example, the chain oxidation is replaced with the conventional high-temperature tube oxidation, and all other conditions are the same as in Example 1.

### Comparative Example 2

In this comparative example, the high-temperature drive-in of step (12) of the diffusion process is omitted, and all other conditions are the same as in Example 1.

### Comparative Example 3

In this comparative example, the chain oxidation process is replaced with a room-temperature chain oxidation process, and all other conditions are the same as in Example 1.

Several batch productions are carried out according to Example 1 and Comparative Example 1 of the present application, and the results are shown in Table 1:

**Table 1**

| | | ΔUOC/A | ΔIsc/A | ΔFF | ΔNcell/% |
|---|---|---|---|---|---|
| First batch production | Example 1 | 0.0013 | 0.020 | 0.04 | 0.09 |
| | Comparative Example 1 | 0 | 0 | 0 | 0 |
| Second batch production | Example 1 | 0.0015 | 0.022 | 0.09 | 0.11 |
| | Comparative Example 1 | 0 | 0 | 0 | 0 |
| Third batch production | Example 1 | 0.0009 | 0.030 | 0.07 | 0.10 |
| | Comparative Example 1 | 0 | 0 | 0 | 0 |

As can be seen from the above table, the conversion efficiency of crystalline silicon solar cells is increased by 0.1% via the shallow junction diffusion emitter prepared in the present application, and the open circuit voltage Uoc and short circuit current Isc are mainly improved.

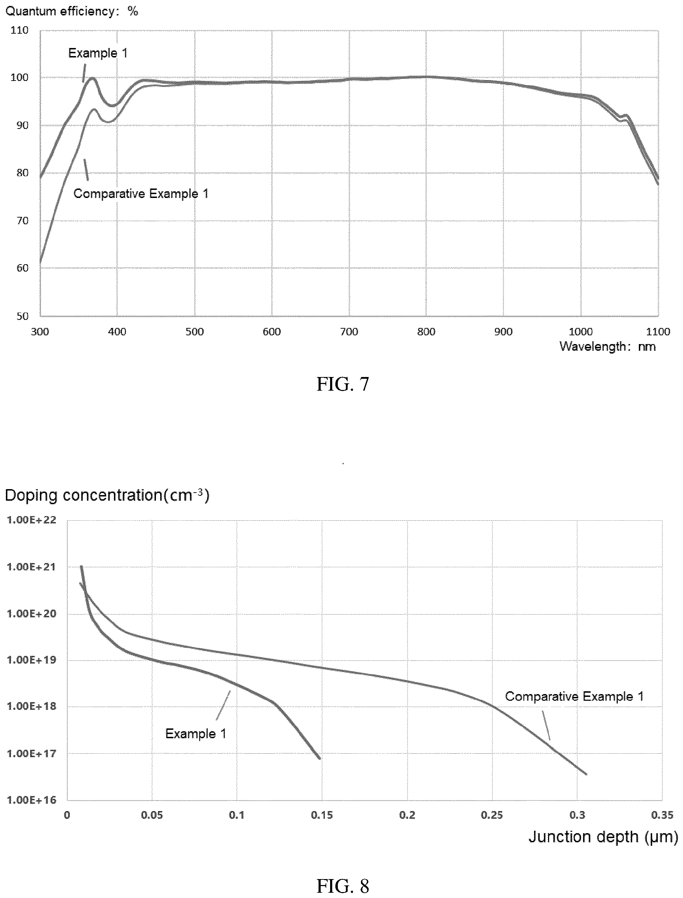

The doping distribution curves of Example 1 and Comparative Example 1 in the present application are shown in FIG. 6, the QE quantum efficiency spectra are shown in FIG. 7, and the ECV (electrochemical corrosion) doping concentration distribution profiles are shown in FIG. 8. Through the QE quantum efficiency spectra of FIG. 7, it is observed that the shortwave response of Example 1 in the range of 300-500 nm is obviously higher than that of Comparative Example 1; as can be seen in FIG. 8, for Example 1 of the present application, the junction depth is 0.15 µm and the surface concentration is 1.0×10²¹ cm⁻³, both of which are superior to that of Comparative Example 1.

The solar cells in Examples 1-8 and Comparative Examples 1-3 are produced in production lines, and test results are shown in Table 2.

**Table 2**

| | ΔUOC/A | ΔIsc/A | ΔFF | ΔNcell/% |
|---|---|---|---|---|
| Example 1 | 0.0013 | 0.020 | 0.04 | 0.09 |
| Example 2 | 0.0010 | 0.0130 | 0.16 | 0.101 |
| Example 3 | 0.0011 | 0.0300 | 0.07 | 0.109 |
| Example 4 | -0.0007 | -0.0099 | 0.00 | -0.040 |
| Example 5 | -0.0004 | -0.0250 | 0.00 | -0.056 |
| Example 6 | -0.0004 | -0.0100 | -0.06 | -0.047 |
| Example 7 | -0.0007 | -0.0181 | -0.08 | -0.077 |
| Example 8 | -0.0010 | -0.0230 | 0.02 | -0.067 |
| Comparative Example 1 | -0.0022 | -0.0169 | -0.02 | -0.108 |
| Comparative Example 2 | -0.0024 | -0.0199 | -0.16 | -0.158 |
| Comparative Example 3 | -0.0035 | -0.0399 | -0.10 | -0.212 |

As can be seen from the above table, the efficiencies of Examples 1-3 are obviously increased by about 0.1%, and the results are consistent; Example 4 replaces the temperature of the first low-temperature diffusion source introduction with a lower temperature, Example 5 increases the temperature of the high-temperature drive-in in the diffusion process, Example 6 further increases the temperature of the high-temperature chain oxidation process, and Example 7 omits the second low-temperature diffusion source introduction; compared with Example 1, the light-conversion efficiencies of Examples 4-6 all decrease. Comparative Example 1 replaces the chain oxidation with high-temperature tube oxidation, Comparative Example 2 omits the high-temperature drive-in process, and Comparative Example 3 replaces the high-temperature chain oxidation with room-temperature chain oxidation, and it can be observed that the light-conversion efficiencies of solar cells further decrease.

The applicant has stated that the above description is only embodiments of the present application, but the scope of the present application is not limited thereto, and it should be apparent to those skilled in the art that any change or substitution which can be readily thought of by those skilled in the art within the technical scope disclosed herein shall fall within the protection scope and disclosure scope of the present application.

## Claims

1. A preparation method for a crystalline silicon solar cell with a shallow junction diffusion emitter, comprising a diffusion process and a chain oxidation process;
the diffusion process comprises low-temperature diffusion and high-temperature drive-in, and the chain oxidation process comprises high-temperature chain oxidation.

2. The preparation method according to claim 1, wherein the diffusion process sequentially comprises boat loading, a first heating, a first temperature holding, vacuum stabilization, vacuum leak detection, oxidation, a first low-temperature diffusion source introduction, a second low-temperature diffusion source introduction, a second heating, a second temperature holding, high-temperature drive-in, a first cooling, complemental diffusion, purge, a PSG deposition reaction, an oxidation reaction, a second cooling, nitrogen filling, and boat unloading;
optionally, the low-temperature diffusion comprises diffusing a constant source at a certain temperature;
the constant source is phosphorus oxychloride;
optionally, the low-temperature diffusion comprises the first low-temperature diffusion source introduction and the second low-temperature diffusion source introduction;
the first low-temperature diffusion source introduction is performed at 770-790°C;
the first low-temperature diffusion source introduction is performed for 220-260 s;
the first low-temperature diffusion source introduction is performed with a low nitrogen flow rate of 1000-1100 sccm;
the first low-temperature diffusion source introduction is performed with an oxygen flow rate of 450-550 sccm;
the first low-temperature diffusion source introduction is performed with a high nitrogen flow rate of 0 sccm;
the first low-temperature diffusion source introduction is performed at a furnace tube pressure of 50-60 mbar;
the second low-temperature diffusion source introduction is performed at 790-810°C;
the second low-temperature diffusion source introduction is performed for 190-230 s;
the second low-temperature diffusion source introduction is performed with a low nitrogen flow rate of 1100-1200 sccm;
the second low-temperature diffusion source introduction is performed with an oxygen flow rate of 550-650 sccm;
the second low-temperature diffusion source introduction is performed with a high nitrogen flow rate of 0 sccm;
the second low-temperature diffusion source introduction is performed at a furnace tube pressure of 50-60 mbar.

3. The preparation method according to claim 1 or 2, wherein the high-temperature drive-in comprises driving a phosphorus source on the surface of crystalline silicon into a silicon matrix at a high temperature;
the high-temperature drive-in is performed for 350-370 s;
the high-temperature drive-in is performed at 800-900°C;
the high-temperature drive-in is performed with a low nitrogen flow rate of 750-850 sccm;
the high-temperature drive-in is performed with an oxygen flow rate of 0 sccm;
the high-temperature drive-in is performed with a high nitrogen flow rate of 950-1050 sccm;
the high-temperature drive-in is performed at a furnace tube pressure of 50-60 mbar.

4. The preparation method according to any one of claims 2 or 3, wherein the PSG deposition reaction is performed at 700-800°C;
the PSG deposition reaction is performed for 700-800 s;
the PSG deposition reaction is performed by introducing phosphorus oxychloride;
the PSG deposition reaction is performed with a low nitrogen flow rate of 1250-1350 sccm;
the PSG deposition reaction is performed with an oxygen flow rate of 550-650 sccm;
the PSG deposition reaction is performed with a high nitrogen flow rate of 0 sccm;
the PSG deposition reaction is performed at a furnace tube pressure of 55-65 mbar.

5. The preparation method according to any one of claims 2-4, wherein a furnace tube is subjected to a vacuum operation in the first heating and the first temperature holding;
optionally, a pipeline is purged by introducing a low nitrogen flow in the first temperature holding, and the purge is performed with a flow rate of 450-550 sccm;
optionally, after the pressure is stabilized in the vacuum stabilization, all gas introductions are cut off and the furnace tube pressure is maintained at 50-60 mbar;
optionally, the oxidation comprises growing a layer of silicon oxide on the surface of a crystalline silicon wafer for protection.

6. The preparation method according to any one of claims 2-5, wherein the second heating is performed to a target temperature of 830-870°C;
the second heating is performed by introducing nitrogen to remove the residual phosphorus oxychloride;
the second heating is performed with a high nitrogen flow rate of 950-1050 sccm;
optionally, the second temperature holding is performed by introducing oxygen to further react with the residual phosphorus oxychloride;
the second temperature holding is performed with an oxygen flow rate of 550-650 sccm.

7. The preparation method according to any one of claims 2-6, wherein the first cooling is performed at 750-810°C;
optionally, the complemental diffusion is used to fix the localized low-doping defect of a crystalline silicon wafer caused by the high-temperature drive-in;
optionally, the purge removes the residual phosphorus oxychloride in the furnace tube;
optionally, the oxidation reaction removes phosphorus oxychloride introduced into the PSG deposition reaction;
optionally, the second cooling is used to fix the lattice dislocation in a crystalline silicon wafer;
optionally, the nitrogen filling is used to restore the atmospheric pressure in the furnace tube.

8. The preparation method according to any one of claims 1-7, wherein the chain oxidation process comprises high-temperature chain oxidation;
the high-temperature chain oxidation is performed at 660-670°C;
the high-temperature chain oxidation is performed for 1-5 min;
the high-temperature chain oxidation is performed with an oxygen flow rate of 95-105 slm;
the high-temperature chain oxidation is performed with a nitrogen flow rate of 5-15 slm.

9. The preparation method according to any one of claims 1-8, wherein the preparation method sequentially comprises the following processes:
a texturing process, the diffusion process, a laser doping process, the chain oxidation process, a PSG removal process, a rear-side alkali polishing process, an annealing process, an ALD passivation process, a PECVD process for the front side, a PECVD process for the rear side, a laser grooving process, a screen-printing process, and a current injection process.

10. Use of the preparation method for a crystalline silicon solar cell with a shallow junction diffusion emitter according to any one of claims 1-9, wherein the preparation method is applied in the field of photovoltaics.
